Europäisches Patentamt

European Patent Office

Office européen des brevets

(19)

(11) Publication number: **0 152 794**
A2

(12) # EUROPEAN PATENT APPLICATION

(21) Application number: 85100690.8

(22) Date of filing: 24.01.85

(51) Int. Cl.⁴: **H 01 L 23/52,** H 01 L 21/48

(30) Priority: 17.02.84 US 581477

(43) Date of publication of application: 28.08.85
Bulletin 85/35

(84) Designated Contracting States: DE FR GB

(71) Applicant: **International Business Machines Corporation,**
**Old Orchard Road, Armonk, N.Y. 10504 (US)**

(72) Inventor: **Tummala, Rao Ramamohana, 13 ShadyBrook**
**Lane, Hopewell Junction New York 12533 (US)**

(74) Representative: **Schröder, Otto H., Dr.-Ing. et al, IBM**
**Switzerland Zurich Patent Operations Säumerstrasse 4,**
**CH-8803 Rüschlikon (CH)**

(54) **Multi-layered electrical interconnection structure.**

(57) An interconnection package for a plurality of semiconductor chips and a method for fabricating same. The method includes the fabrication of a multi-layered glass-ceramic base (32), and the repeated steps of depositing a conductor pattern (48) on the base and forming thereon a crystallizable glass dielectric layer (50) which is then crystallized to a glass-ceramic prior to further additions of conductor patterns and crystallizable glass layers to form a monolithic compatible substrate (30) all through. The composition of the crystallizable glass dielectric layers is a borosilicate glass containing 50 to 70% cordierite.

## MULTI-LAYERED ELECTRICAL INTERCONNECTION STRUCTURE

This invention relates to semiconductor packaging and more particularly to a multi-layered electrical interconnection structure adapted for having bonded thereto semiconductor integrated circuit chips. Also described is a method for fabricating such structures as well as a ceramic composition having a low thermal expansion coefficient and a low dielectric constant that can be employed.

As the integrated circuit technology advances towards large scale integration in high performance circuits, it is necessary to provide interconnection electrical packaging which is compatible with the performance demands of the associated circuitry. Thus, the problems of signal delay, package impedance, and cross talk are extremely critical. Known prior art packaging materials often do not possess appropriate controllable dielectric properties to accommodate high performance circuits in large scale integration schemes.

A high quality glass-metal package would appear to offer one solution to the problem. By simply changing the specific glass composition, the various desired ranges of properties are readily controllable and selectable. It has relatively high strength, and its chemically inert and thermally stable properties are extremely adaptable for known upper surface chip bonding techniques.

Despite the desirability of employing glass as the dielectric insulating layer in multilayer interconnection packages, known processes for fabricating a multi-level package are almost non-existent or result in such poor quality products that the advantages attributable to certain dielectric properties of the selected glass are defeated.

Generally, one basic problem in forming multi-level glass layers is traced to the formation of bubbles occurring during the firing step. One type of bubble results from the decomposition of organic materials present on the surface upon which the glass layer is being deposited. This decomposition causes evolution of gases that are trapped or absorbed by the upper glass layer. The consequence of this type of bubble formation is to create voids in the glass structure. During subsequent metal evaporation steps, these voids or openings often cause electrical shorting due to metallization forming in the voids or openings. Also, the voids trap extraneous material so as to further aggravate the contamination problem. Even if the bubble remains intact or does not break in the glass, its presence often destroys the planarity of the upper glass surface so as to impair subsequent processing operations, such as the photolithographic steps, particularly with extremely fine lines as will be described later.

A second type of bubble or closed cell structure also creates problems in the formation of multi-layer glass modules. The gaseous ambient surrounding the glass during the firing step forms bubbles in the glass layer. A closed cell or bubble is formed as the glass layer enters the sintering phase. Sintering is that point at which the solid glass particles start to soften under the exposure to heat, and begin to join or coalesce with adjacent particles.  At the sintering temperature, the glass is not capable of reflowing into a homogeneous body without the formation of bubbles.

As adjacent solid glass particles (having random geometrical shapes) begin to join, a close cavity is formed.  Stated in another way, necks are grown between two adjacent glass particles, and then the necks continue to grow between other pairs of particles, and thus ultimately, between all particles.  At this point, an interconnected network of sintered glass particles are formed with enclosed voids throughout the network.  This existence of this network prevents the fabrication of high quality multi-layer glass-metal modules having the desired impedance and planarity characteristics.

The prior art in the general glass area has suggested that bubble-free glass layers can be formed by outdiffusing the bubbles at a very high temperature.  Often, this outdiffusion occurs in different gaseous ambients. However, this approach is totally unsuitable for the present multi-layer glass-metal modules, because the relatively high temperatures required to outwardly diffuse the trapped bubble in the glass layer would completely destroy and disrupt previously deposited metallization lines and vertical metallic interconnection studs existing within the glass body, as well as underlying glass layers.

A high quality bubble-free structure is also theoretically achievable by firing the glass in a complete vacuum.  However, this approach causes a considerable number of practical problems, particularly in large scale manufacturing operations due to the unfeasibility of working in this ambient.

Sputtering of successive glass layers to form a multi-level glass-metal package is another possible approach. However, this technique gives rise to significant disadvantages from a process and structural standpoint. Firstly, the sputtering process does not lend itself to the practical fabrication of glass layers of any appreciable thickness, which are sometimes necessary in order to obtain the desired impedance characteristics for the particular package designed. Further, it is not workable to build up a plurality of glass layers having interposed metallization patterns, and yet maintain each of the individual metallization patterns in a single plane.

In U. S. Patents 3,726,001 and 3,968,193, it has been proposed to form a high-quality and high performance multilayer substrate for interconnection to semiconductor devices, by fabricating a complex thin film interconnection package on a dissimilar refractory (e.g. alumina) substrate, by forming a plurality of bubble-free layers of glass over the substrate, depositing a plurality of thin film metallization patterns on each layer of deposited glass, selectively depositing vertical conductive studs for electrical interconnection between various conductive patterns, and bonding a plurality of integrated circuit chips to the upper surface of the glass package. Although this method has received acceptance in the technology, it nevertheless suffers from the disadvantage of requiring extreme care and attention in fabrication in order to avoid loss of integrity. It should be noted that alumina substrate, because of its high thermal expansion coefficient compared to silicon does not allow bonding of larger chips.

For example, as noted in the said patents, since the significant factor in working glass is its firing temperature it is necessary to take into close account the sintering temperatures of the glasses to avoid disruptions underlying metallization. Thus, where like glasses are used, the sintering temperatures can soften the underlying glass layers resulting in viscous deformation thereof with danger of accompanying displacement of the metallization patterns.

Also present is the danger of glass cracking, which requires critical matching of the thermal coefficients of expansion between the multilayer glass component and the multilayered ceramic component which is coped with in the last said patents by providing a compromised relationship of stresses, e.g. where, in the resultant package, the glass-component is in a state of compression whereas the underlying ceramic component is in a state of tension, a condition which detracts from the integrity of the package.

Attempts to obtain a glass-ceramic having a sufficiently low dielectric constant and a low thermal expansion coefficient were described in the patent to Yamada et al, U.S. 4,313,026 and in the patent to Narken et al, U.S. 4,221,047. Yamada et al has a preferred glass ceramic consisting of 50 wt% borosilicate glass and 50 wt % alumina. Narken et al has a crystallizable magnesium glass composition. Both of these patents cover compositions that still have relatively high dielectric constants in the range of 5.5 to 5.1.

It is a primary object of this invention to provide a glass-ceramic layer composition that has a small dielectric coefficient and a small thermal expansion coefficient.

It is another object of this invention to provide an improved multilayered support for interconnection to semiconductor devices.

It is still another object of this invention to provide electrical interconnection for a plurality of integrated circuit semiconductor chips through a glass-ceramic carrier having a multilayered distribution of interconnected thick and thin film metallization pattern.

It is a further object of this invention to provide a bubble-free glass-ceramic and metal interconnection package which can be fabricated at temperatures which avoid distortion of underlying metallized patterns and vertical interconnecting studs.

It is a still further object of this invention to provide means for fabricating on a pre-formed glass-ceramic substrate containing a multilayered distribution of thick films copper conductive patterns, an integrated multilayered distribution of thin film copper metallurgy interleaved with layers of glass-ceramic layers, each of which has been individually formed without distortion of prior formed metallurgy and glass-ceramic layers below the melting point of copper.

The invention as claimed is intended to meet these and other objects and to remedy the drawbacks encountered with hitherto known techniques.

The advantages offered by the invention are mainly that the described multi-layer glass-ceramic substrate provides for a very low dielectric constant (of 4.1) and a thermal expansion closely matching that of silicon thereby permitting the bonding of large chips. These advantages can be accomplished employing a relatively straight forward fabrication process such as that described hereinafter.

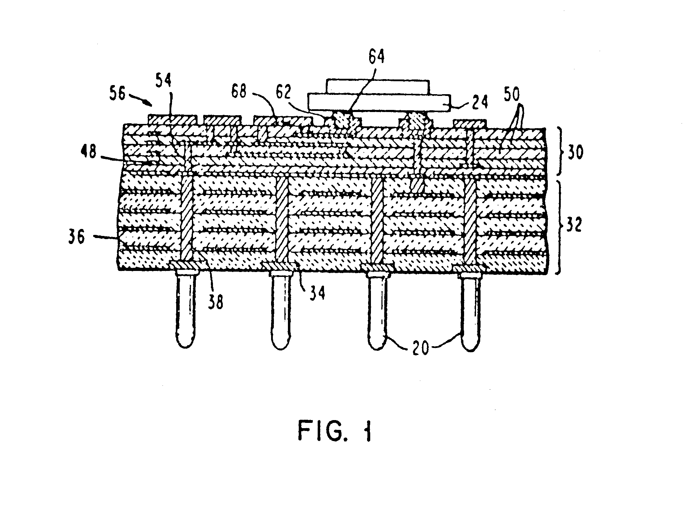

One way of carrying out the invention is described in detail below with reference to a drawing (Figure 1) which shows a specific embodiment. The figure is a partial cross-sectional view illustrating the multilevels of interconnections in a structure in accordance with the invention.

In Figure 1 the structural details of the complex interconnection structure necessary to communicate from the outside world via a plurality of pins 20 to a plurality of chips 24 are illustrated. The thick film interconnection metallurgy also establishes voltage distribution planes, ground planes, X-Y signal planes, and voltage redistribution planes.

In this preferred embodiment, a glass-metal package 30 is joined to a pre-formed multi-layer glass-ceramic base 32. A plurality of pads 34 located on the under surface of the multi-layer ceramic base member 32 each connect to the pins 20. In the preferred embodiment, the pads 34 comprise a nickel plated tungsten metal, which are then joined to the pins 20 by brazing.

The multi-layer glass-ceramic base member 32 includes a multi-level thick film metallization generally indicated at 36 at a plurality of planes. Further vertical conductive paths through the multi-layer glass-ceramic base member 32 are provided by a plurality of metal-filled vias 38. The base member 32 electrically functions to provide voltage distribution planes. The number of voltage distribution planes are governed by the voltage requirements of the circuit logic family existing at the chip level.

The glass-ceramic/metal superstructure 30 comprises metallurgy generally shown at 48 located at multi-levels or planes separated by a plurality of insulating glass-ceramic layers 50. Vertical interconnections between different levels and the multi-layer glass-ceramic substrate 32 are provided by a plurality of studs 54.

The top level metallurgy is generally designated by the numeral 56. The semiconductor chips 24 are joined to predetermined conductive paths by a metallurgical system and solder connection illustrated at 62 and 64, respectively.

In order to allow for engineering changes, the top level metallurgy 56 is provided with engineering change Pads 68. Basically, the engineering change pads 68 comprise a material which is softer than the metallurgy 56 itself. Accordingly, severing pressure applied on the upper surface of the metallurgy 56 in the area of the pad 68 breaks the metal line. Re-routes or engineering changes are then available by making other connection, for example, wire bonding. Only one engineering change pad 68 is illustrated; however, in actual practice, numerous pads would be located throughout the upper layer metallurgy. Pads 68 may be formed of a material such as a polyimide polymer which would cushion any severing forces, thus preventing damage to the upper glass layer surface, but their existence is not absolutely required in all instances.

A multilayer glass-ceramic substrate capable of low dielectric constant and thermal expansion closely matching silicon with thin or thick film metallization is obtained by first melting a glass composition 10 - 20% $B_2O_3$, 55 - 65% $SiO_2$, 10 - 15% $Al_2O_3$ and 8 - 15% MgO. The glass is then powdered, slurried in suitable organics and deposited as thin film or greensheet and heat treated around 950°C to form alpha cordierite crystal and borosilicatee glass. Metallization is screened in between greensheet layers or surface metallized by thin film techniques to form interconnecting multilayer structures capable of wiring and supporting a number of silicon chips.

In accordance with this invention the improved properties of the electrical interconnection package are due to the step of forming a borosilicate glass layer containing an $\alpha$-cordierite crystallizable glass component therein. The amount of $\alpha$-cordierite glass present in the glass layer is 50 to 70 vol.% with the preferred concentration being 60 vol.%.

The glass layer composition which contains the $\alpha$-cordierite has 10 to 20% $B_2O_3$, 55 to 65% $SiO_2$, 10 to 15% $Al_2O_3$ and 8 to 15% MgO. These compositions have a thermal expansion coefficient of about $16 \times 10^{-7}$/°C which is similar to silicon and a dielectric constant of about 4.1.

Examples of borosilicate glasses that contain α-corderite glass are set forth in the following table.

| Oxide | Example, Wt % | |
|---|---|---|
| | No. 1 | No. 2 |
| $B_2O_3$ | 15 | 12 |
| $SiO_2$ | 60 | 62 |
| $Al_2O_3$ | 12 | 12 |
| $Na_2O$ | 1 | 1 |
| $K_2O$ | 0 | 1 |
| $Li_2O$ | 0 | 0 |
| MgO | 10 | 10 |
| $P_2O_5$ | 2 | 2 |
| THERMAL EXPANSION $(10^{-7}/°C)$ | 16 | 15 |
| PERCENT CRYSTALLIVITY | 55 | 60 |
| DIELECTRIC CONSTANT | 4.1 | 4.3 |
| GLASSY PHASE | BORO-SILICATE | BORO-SILICATE |

Although preferred embodiments have been described, it is understood that numerous variations may be made in accordance with the principles of this invention.

## C L A I M S

1.   A  multi-layered  electrical  interconnection structure adapted for having bonded thereto semiconductor integrated  circuit  chips,  characterized  in  that  said structure comprises:

a  dielectric  base  (32)  having  at  least  two  spaced and  interconnected  levels  of  electrical  conductor  patterns  (36)  embedded  therein  and  having  first  terminal portions  (38)  extending  to  at  least  one  of  its  lower  or upper  surfaces  for  connection  to  additional  circuits;  and

a  dielectric  package  (30)  having  disposed  therein  at least  two  spaced  and  interconnected  levels  of  additional electrical  conductor  patterns  (48),  and  having  second terminal  portions  (54)  extending  to  the  top  surface  of said  package  for  connection  to  external  circuits,  said package  being  comprised  of  at  least  one  borosilicate glass  layer  having  homogeneously  dispersed  therein $\alpha$-cordierite glass-ceramic crystallites.

2.   The  structure  of  claim  1  wherein  said  glass layer contains from about 50 to about 70 volume % of said crystallites.

3.   The  structure  of  claim  1  wherein  said  glass layer comprises 10 to 20% $B_2O_3$, 55 to 65% $SiO_2$, 10 to 15% $Al_2O_3$ and 8 to 15% MgO.

4.   A  method  for  fabricating  a  multi-layered electrical  interconnection  structure  adapted  for  bonding to  semiconductor  integrated  circuit  chips,  characterized in that the method comprises:

a) providing a dielectric base (32) having a plurality of conductive planes (36) interconnected together in a predetermined pattern;

b) forming a first coating (48) of a conductive pattern on the upper surface of said base (32) in a predetermined pattern of interconnections to said conductive planes (36);

c) forming a plurality of conductive studs (54) on said upper surface and coating in a predetermined pattern of interconnections to said conductive planes and coating;

d) forming over said base, inclusive of said upper surface, coating and studs, a glass layer comprised of a borosilicate glass containing an α-cordierite crystallizable glass component;

e) heating said glass layer (50) to the crystallization temperature of said component for crystallization thereof into crystals dispersed in a borosilicate glass binder; and

f) conditioning the crystallized glass layer to expose at the top surface thereof said studs (54).

5. The method of claim 4 including the additional steps of:

g) forming on said exposed top surface an additional coating of a conductive pattern in 'a predetermined pattern of interconnections to underlying planes, patterns and studs;

h) forming a plurality of additional conductive studs on said top surface in a predetermined pattern of interconnections to underlying conductive planes, patterns and studs;

i) forming over said top surface an additional glass layer comprised of a borosilicate glass containing a α-cordierite crystallizable glass component;

j) heating said glass layer to crystallize said component into α-cordierite crystals dispersed in a borosilicate glass binder; and

k) conditioning the last said crystallized glass layer to expose at the top surface thereof the immediate underlying studs.

6. The method of claim 5 including repeating steps g to k thereof to obtain a desired number of levels of said conductive patterns.

7. The method of claim 4, 5 or 6 including electrically connecting at least one of said chips (24) to said exposed studs (54).

8. A borosilicate glass-cordierite ceramic composition having a low thermal expansion coefficient and a low dielectric constant, characterized in that it comprise 10 to 20 wt % $B_2O_3$, 55 to 65 wt % $SiO_2$, 10 to 15 wt % $Al_2O_3$ and 8 to 15 wt % MgO.

FIG. 1